(19) Europäisches Patentamt / European Patent Office / Office européen des brevets

(11) **EP 3 595 113 B1**

(12) **EUROPEAN PATENT SPECIFICATION**

(45) Date of publication and mention
of the grant of the patent:
**20.01.2021 Bulletin 2021/03**

(51) Int Cl.:
***H02H 1/06*** *(2006.01)*   ***H02H 3/04*** *(2006.01)*
***G01R 31/327*** *(2006.01)*   ***H02H 3/33*** *(2006.01)*

(21) Application number: **17899341.6**

(22) Date of filing: **10.03.2017**

(86) International application number:
**PCT/JP2017/009746**

(87) International publication number:
**WO 2018/163413 (13.09.2018 Gazette 2018/37)**

(54) **SYSTEM WITH ELECTRONIC CIRCUIT BREAKER**

SYSTEM MIT ELEKTRONISCHEM SCHUTZSCHALTER

SYSTÈME AVEC DISJONCTEUR ÉLECTRONIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**15.01.2020 Bulletin 2020/03**

(73) Proprietor: **Mitsubishi Electric Corporation
Chiyoda-ku
Tokyo 100-8310 (JP)**

(72) Inventors:
• **CHIKAI, Masataka
Tokyo 102-0073 (JP)**
• **TAKIGAWA, Yusuke
Tokyo 100-8310 (JP)**

• **HARADA, Kouki
Tokyo 100-8310 (JP)**
• **NOMURA, Toshimitsu
Tokyo 100-8310 (JP)**

(74) Representative: **Diehl & Partner
Patent- und Rechtsanwaltskanzlei mbB
Erika-Mann-Straße 9
80636 München (DE)**

(56) References cited:
EP-A1- 2 051 359   JP-A- H08 331 748
JP-A- H09 166 634   JP-A- H09 211 089
JP-A- H09 211 089   JP-A- 2014 039 408

**Description**

Technical Field

The present invention relates to a system comprising an electronic circuit breaker such that an independent test operation can be carried out offline using an external power supply from a test device, and relates in particular to a power supply circuit of the electronic circuit breaker.

Background Art

An electronic circuit breaker including an electronic current detection device and a tripping device, and having a circuit configuration such that one portion of a detection current is utilized in an operation power supply of an electronic circuit, is disclosed in, for example, JP-A-8-331748 (Patent Document 1) as existing technology relating to an electronic circuit breaker. Also, a test device such that power consumption when testing an electronic circuit breaker having one portion of a detection current as an electronic circuit operation power supply is reduced, and operation tests are carried out individually offline on circuits configured by dividing a tripping detection circuit into instantaneous tripping and time-limit tripping, is disclosed in, for example, JP-A-9-211089 (Patent Document 2).
Features of the preamble of independent claim 1 are known from the embodiment of Figure 2 of the document. JP H09-211089 A.

Citation List

Patent Literature

    Patent Document 1: JP-A-8-331748
    Patent Document 2: JP-A-9-211089

Summary of Invention

Technical Problem

The electronic circuit breaker disclosed in Patent Document 1 is a circuit breaker such that one portion of a detection current is utilized in an operation power supply of a control circuit, wherein output of a rectifier circuit that converts a secondary current of a current transformer, which detects a current of an alternating current circuit into a unidirectional current, is divided by a switching element to a smoothing capacitor side and a current detection resistor side, an instantaneous tripping circuit is caused to operate by voltage of the current detection resistor being monitored, and an output voltage of the smoothing capacitor is utilized as the operation power supply of the control circuit.

Also, the electronic circuit breaker test device disclosed in Patent Document 2 is such that power consumption when testing an electronic circuit breaker having one portion of a detection current as an operation power supply of an electronic circuit is reduced, and operation tests are carried out individually offline on circuits configured by dividing a tripping detection circuit into instantaneous tripping and time-limit tripping.

The inventor of the present application has created an electronic circuit breaker shown in Fig. 1 based on Patent Document 1 and Patent Document 2. Fig. 1 is a block diagram showing an electronic circuit breaker wherein the test device disclosed in Patent Document 2 is combined with the circuit breaker disclosed in Patent Document 1, and shows an electronic circuit breaker of a process leading to the invention.

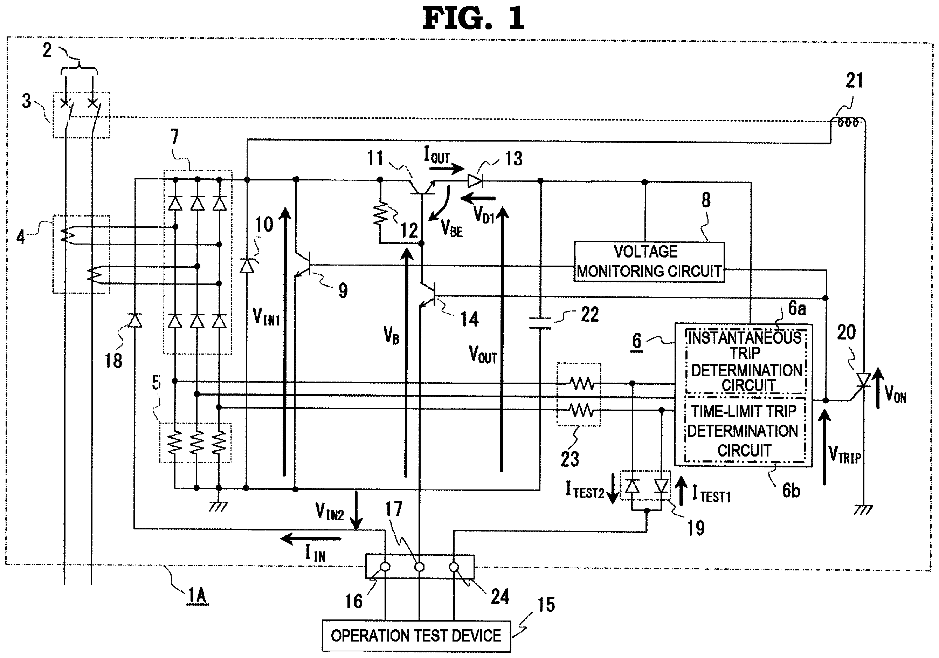

In Fig. 1, an electronic circuit breaker 1A includes a switching contact 3 that opens and closes an alternating current electric path 2, a current detection resistor 5 that is connected to a secondary side of a current transformer 4 inserted in the alternating current electric path 2 and converts an output current of the current transformer 4 into a detection voltage, a determination circuit 6 having two kinds of determination circuits, those being an instantaneous trip determination circuit 6a, which determines an overcurrent from the detection voltage of the current detection resistor 5, and a time-limit trip determination circuit 6b, and a power supply circuit that converts a current output by a rectifier circuit 7, which rectifies a current output by the current transformer 4, into a voltage source, and supplies power to the determination circuit 6. The power supply circuit is configured of a voltage monitoring circuit 8, a current control transistor 9, which is a first switching element, an overvoltage protection Zener diode 10, a load isolating transistor 11, which is a second switching element, a pull-up resistor 12, a backflow preventing diode 13, and a control transistor 14, which is a third switching element controlling the load isolating transistor 11. Each of the current control transistor 9, the load

**EP 3 595 113 B1**

isolating transistor 11, and the control transistor 14 is configured of a bipolar transistor or a field effect transistor.

Also, the electronic circuit breaker 1A is configured to include a rectifying diode 18 that prevents a reverse current when power is supplied from an operation test device 15 via terminals 16 and 17, a switching diode 19 that switches between an instantaneous tripping signal and a time-limit tripping signal output from the operation test device 15, a tripping coil 21 biased via a thyristor 20 by an output signal of the determination circuit 6, and a tripping mechanism (not shown) that drives the switching contact 3 so as to open when the tripping coil 21 is biased. Reference sign 22 indicates a smoothing capacitor, reference sign 23 indicates a testing detection resistor, and reference sign 24 indicates a terminal that supplies an operation test signal of the operation test device 15 to the switching diode 19.

The electronic circuit breaker 1A shown in Fig. 1 is configured as previously described, and a power supply to the circuit needs to be input from an exterior when an operation using the operation test device 15 is offline with no energization of the alternating current electric path 2, because of which a constant current $I_{IN}$ of an interior of the connected operation test device 15 is supplied from the terminal 16 to the power supply circuit via the rectifying diode 18.

The smoothing capacitor 22 is charged with the constant current $I_{IN}$ via the load isolating transistor 11, whereby the constant current $I_{IN}$ is converted into an output voltage $V_{OUT}$, and supplied to the determination circuit 6. The output voltage $V_{OUT}$ is detected by the voltage monitoring circuit 8, and when the output voltage $V_{OUT}$ is greater than a predetermined threshold, control of the output voltage $V_{OUT}$ is carried out by a signal being output to a base of the current control transistor 9, and the constant current $I_{IN}$ being diverted to a ground via the current control transistor 9.

After the output voltage $V_{OUT}$ rises and the determination circuit 6 starts up, the operation test device 15 selects one determination circuit of the instantaneous trip determination circuit 6a, which determines an instantaneous operation test signal, and the time-limit trip determination circuit 6b, which determines a time-limit trip test signal, and supplies an operation test signal $I_{TEST1}$ or $I_{TEST2}$ of a constant current from the terminal 24. The operation test signal $I_{TEST1}$ or $I_{TEST2}$ causes a voltage equivalent to an application of an overcurrent to be generated using the testing detection resistor 23 and the current detection resistor 5, causing a pseudo overcurrent to be detected by one of the instantaneous trip determination circuit 6a and the time-limit trip determination circuit 6b of the determination circuit 6. The terminal 17 is a ground.

When a detected voltage value exceeds a predetermined threshold, either the instantaneous trip determination circuit 6a or the time-limit trip determination circuit 6b of the determination circuit 6 outputs a tripping signal $V_{TRIP}$ to a gate of the thyristor 20, thereby putting the thyristor 20 in an on-state. Also, the control transistor 14 of the power supply circuit changes to an on-state, a base-to-emitter voltage of the load isolating transistor 11 becomes a ground potential, and the output voltage $V_{OUT}$ becomes approximately equal to 0V. At the same time, an output of the voltage monitoring circuit 8 is turned off, the current control transistor 9 changes to an off-state, and the constant current $I_{IN}$ flows into the tripping coil 21. Because of this, the tripping coil 21 drives, opening the switching contact 3.

Meanwhile, a tripping operation detection voltage $V_{IN2}$ between the terminal 16 of the operation test device 15 and the ground is such that when the load isolating transistor 11 is in an off-state, the current control transistor 9 is in an off-state, and impedance of the tripping coil 21 is greater than that of the determination circuit 6, which is a load of the power supply circuit, the tripping operation detection voltage $V_{IN2}$ rises in comparison with that before a tripping operation. When the operation test device 15 is detecting the tripping operation detection voltage $V_{IN2}$, and a state wherein a predetermined tripping operation detection threshold is exceeded is maintained for several milliseconds, the operation test device 15 detects a tripping operation of the electronic circuit breaker 1A, and carries out a detection of a tripping operation time. Note that in order for the operation test device 15 to carry out tripping detection, it is necessary for the power supply to the determination circuit 6 to be supplemented with only an electrical charge with which the smoothing capacitor 22 is charged for the time for which the tripping operation detection is carried out, meaning that a large capacity smoothing capacitor is needed.

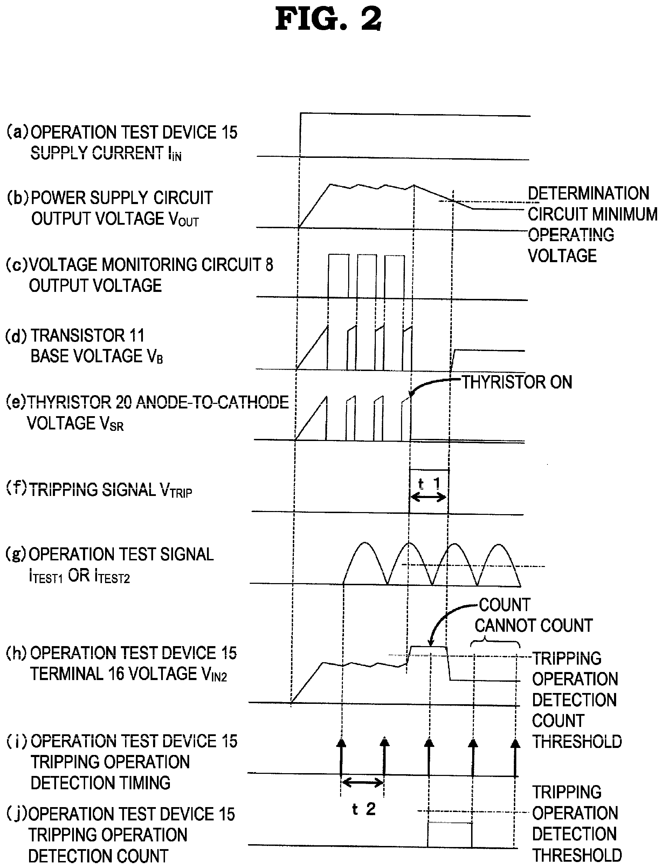

Operation waveforms when the electronic circuit breaker 1A shown in Fig. 1 becomes a problem are shown in Fig. 2. In Fig. 2, (a) shows the supply current $I_{IN}$ of the operation test device 15, (b) shows the output voltage $V_{OUT}$ of the power supply circuit, (c) shows an output voltage of the voltage monitoring circuit 8, (d) shows a base voltage $V_B$ of the load isolating transistor 11, and (e) shows an anode-to-cathode voltage $V_{SR}$ of the thyristor 20. Also, (f) shows the tripping signal $V_{TRIP}$, (g) shows the operation test signal $I_{TEST1}$ or $I_{TEST2}$, (h) shows the voltage $V_{IN2}$ of the terminal 16 of the operation test device 15, (i) shows a timing of a tripping operation detection by the operation test device 15, and (j) shows a count of tripping operation detections by the operation test device 15.

When the operation test signal $I_{TEST1}$ or $I_{TEST2}$ is applied, a tripping signal is output from one determination circuit of the instantaneous trip determination circuit 6a and the time-limit trip determination circuit 6b of the determination circuit 6, and the thyristor 20 changes to an on-state, as in Fig. 2(e). At the same time, the control transistor 14 of the load isolating transistor 11 changes to an on-state, and the potential of the base of the load isolating transistor 11 becomes practically the same as the ground potential, because of which the load isolating transistor 11 is isolated from the load, and changes to an off-state. While the load isolating transistor 11 is in an off-state, the power supply to the determination circuit 6 is only the charging current of the smoothing capacitor 22, and a time for which a tripping operation output signal from each of the instantaneous trip determination circuit 6a and the time-limit trip determination circuit 6b

3

is maintained depends on the remaining charge of the smoothing capacitor 22, becoming t1, as shown in Fig. 2(f).

In order to ensure reliability of tripping operation detection, detection is carried out n times at a tripping operation detection timing t2, as shown in Fig. 2(i). Assuming that the operation test device 15 carries out a tripping operation detection when a predetermined threshold is exceeded by the voltage of the tripping operation detection voltage $V_{IN2}$ terminal exceeding the tripping detection voltage threshold and the count being increased n times, as shown in Fig. 2(j), it is necessary that the time for which a tripping signal is maintained is $t1 \geq (t2 \times n)$.

When the capacity of the smoothing capacitor 22 is small, however, the time for which a tripping operation output signal is maintained is $t1 < (t2 \times n)$, and the operation test device 15 cannot detect a tripping operation. Also, the control transistor 14 changes to an off-state after the tripping signal $V_{TRIP}$ is stopped, because of which the load isolating transistor 11 returns to an on-state, and the supply of current to the determination circuit 6 is restarted. Meanwhile, as the thyristor 20 is maintained in an on-state, the input current is divided between the tripping coil 21 and the power supply circuit, and the output voltage $V_{OUT}$ is maintained in a state wherein the output voltage $V_{OUT}$ does not reach the start-up voltage of the determination circuit 6, because of which the operation test device 15 cannot detect a tripping operation.

When a large capacity smoothing capacitor is used as the smoothing capacitor 22, the operation test device 15 can carry out a tripping detection, but a problem occurs in that a rise time of the power supply circuit output voltage is affected, and a high speed operation cannot be carried out.

The invention, having been contrived in order to resolve the previously described kind of problem, has an object of obtaining an electronic circuit breaker such that a miniaturization of an electronic circuit is obtained by reducing the capacity of a smoothing capacitor, and a high speed operation can be carried out by reducing the capacity of the smoothing capacitor.

Solution to Problem

The above object is solved by the combination of features of independent claim 1. Preferred embodiments are defined in the dependent claims.

A system according to the invention comprises an electronic circuit breaker and an operation test device. The electronic circuit breaker includes a switching contact, inserted in an alternating current electric path, on which a switching operation is carried out by a tripping coil, a rectifier circuit, connected to a secondary side of a current transformer that detects a current flowing into the alternating current electric path, that converts a secondary side output current into a unidirectional current, a first switching element connected to an output side of the rectifier circuit, a second switching element that isolates a load from the output side of the rectifier circuit, voltage switching means, connected to a control terminal of the second switching element, that switches an output voltage of a power supply circuit connected to a thyristor connected in series to the tripping coil, voltage restricting means connected to an output side of the second switching element, a voltage monitoring circuit, connected via the voltage restricting means, that carries out a control of the first switching element, a current detection resistor, connected to the rectifier circuit, that detects a current of each phase of the alternating current electric path, a determination circuit, formed of an instantaneous trip determination circuit and a time-limit trip determination circuit, that is connected via the voltage restricting means, monitors a voltage generated by a current flowing into the current detection resistor, and causes the switching contact to open via the tripping coil when the monitored voltage exceeds a predetermined threshold, a testing detection resistor, connected to the current detection resistor, that is connected in series to an input terminal of the determination circuit. Wherein the operation test device, when the alternating current electric path is offline, inputs a constant current into a latter stage of the rectifier circuit from an exterior via a connection connector, inputs a test signal into the testing detection resistor, and carries out a tripping operation test on the circuit breaker.

Advantageous Effects of Invention

According to the electronic circuit breaker, the capacity of a smoothing capacitor can be reduced by including means of switching a power supply circuit output voltage and means of restricting an output current of the power supply circuit when a tripping coil operates, because of which a miniaturization of an electronic circuit is achieved, and a high speed operation can be carried out by reducing the capacity of the smoothing capacitor.

The foregoing and other objects, features, aspects and advantages of the present invention will become more apparent from the following detailed description of the invention when taken in conjunction with the accompanying drawings.

Brief Description of Drawings

[Fig. 1] Fig. 1 is a block diagram showing an electronic circuit breaker of a process leading to this invention created by the inventor of the present application.

[Fig. 2] Fig. 2 is a chart diagram showing operation waveforms of the electronic circuit breaker shown in Fig. 1.

[Fig. 3] Fig. 3 is a block diagram showing a configuration of a system comprising an electronic circuit breaker and an operation test device according to a first embodiment of the invention.

[Fig. 4] Fig. 4 is a chart diagram showing operation waveforms of the electronic circuit breaker according to the first embodiment of the invention.

Description of Embodiments

Hereafter, referring to the drawings, a preferred embodiment of an electronic circuit breaker according to the invention will be described.

First Embodiment

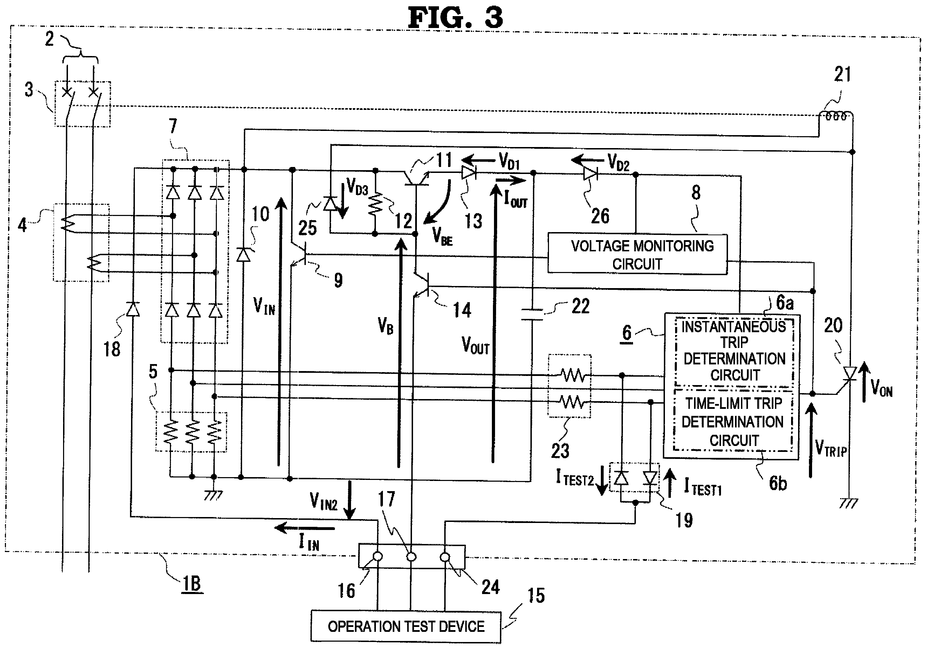

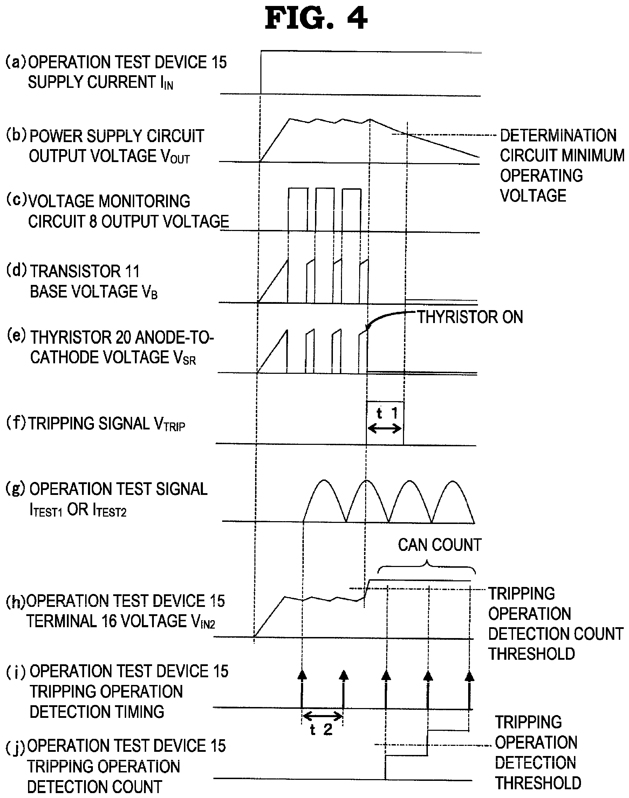

Fig. 3 is a block diagram showing a configuration of a system comprising an electronic circuit breaker and an operation test device according to a first embodiment of the invention, and Fig. 4 is a chart diagram showing operation waveforms of the electronic circuit breaker.

In Fig. 3, an electronic circuit breaker 1B includes a switching contact 3 that opens and closes an alternating current electric path 2, a current detection resistor 5 that is connected to a secondary side of a current transformer 4 inserted in the alternating current electric path 2 and converts an output current of the current transformer 4 into a detection voltage, a determination circuit 6 having two kinds of determination circuits, those being an instantaneous trip determination circuit 6a, which determines an overcurrent from the detection voltage of the current detection resistor 5, and a time-limit trip determination circuit 6b, and a power supply circuit that converts a current output by a rectifier circuit 7, which rectifies a current output by the current transformer 4, into a voltage source, and supplies power to the determination circuit 6. The power supply circuit is configured of a voltage monitoring circuit 8, a current control transistor 9, which is a first switching element, an overvoltage protection Zener diode 10, a load isolating transistor 11, which is a second switching element, a pull-up resistor 12, a backflow preventing diode 13, and a control transistor 14, which is a third switching element controlling the load isolating transistor 11, and in addition, a first diode 25, which is voltage switching means that switches voltage output by the power supply circuit, and a second diode 26, which is voltage restricting means, to be described hereafter. Each of the current control transistor 9, the load isolating transistor 11, and the control transistor 14 is configured of a bipolar transistor or a field effect transistor.

Also, the electronic circuit breaker 1B is configured to include a rectifying diode 18 that prevents a reverse current when power is supplied from an operation test device 15 via terminals 16 and 17, a switching diode 19 that switches between an instantaneous tripping signal and a time-limit tripping signal from the operation test device 15, a tripping coil 21 biased via a thyristor 20 of a switching element by an output signal of the determination circuit 6, and a tripping mechanism (not shown) that drives the switching contact 3 so as to open when the tripping coil 21 is biased. Reference sign 22 indicates a smoothing capacitor, reference sign 23 indicates a testing detection resistor, and reference sign 24 indicates a terminal that supplies an operation test signal of the operation test device 15 to the switching diode 19.

The electronic circuit breaker 1B according to the first embodiment is configured as previously described, and the power supply circuit thereof, that is, the power supply circuit configured of the voltage monitoring circuit 8, the current control transistor 9, the overvoltage protection Zener diode 10, the load isolating transistor 11, the pull-up resistor 12, the backflow preventing diode 13, the control transistor 14 of the load isolating transistor 11, the first diode 25, and the second diode 26, converts an alternating current input from the alternating current electric path 2 via the current transformer 4 into a predetermined direct current voltage, and supplies power to the determination circuit 6. Further, the power supply circuit is turned off when the thyristor 20 is turned on, $I_{OUT}$ becomes approximately equal to 0, a voltage $V_{IN1}$ is caused to rise, and a supply of power to the tripping coil 21 is carried out.

Hereafter, details of the previously described power supply circuit will be described using the chart diagram showing the operation waveforms in Fig. 4. Fig. 4 (a) shows a supply current $I_{IN}$ of the operation test device 15, (b) shows an output voltage $V_{OUT}$ of the power supply circuit, (c) shows an output voltage of the voltage monitoring circuit 8, (d) shows a base voltage $V_B$ of the load isolating transistor 11, and (e) shows an anode-to-cathode voltage $V_{SR}$ of the thyristor 20. Also, (f) shows a tripping signal $V_{TRIP}$, (g) shows an operation test signal $I_{TEST1}$ or $I_{TEST2}$, (h) shows a voltage $V_{IN2}$ of the terminal 16 of the operation test device 15, (i) shows a timing of a tripping operation detection by the operation test device 15, and (j) shows a count of tripping operation detections by the operation test device 15.

When the direct constant current $I_{IN}$ is supplied from the operation test device 15, as shown in Fig. 4 (a), in an offline state wherein the switching contact 3 is opened, a current is supplied to the base of the load isolating transistor 11 via the pull-up resistor 12 and the base voltage $V_B$ rises, as shown in Fig. 4(d), the smoothing capacitor 22 is charged with an electrical charge, and power is supplied to the determination circuit 6, as shown in Fig. 4(b).

The output voltage $V_{OUT}$ of the power supply circuit is detected in the voltage monitoring circuit 8 via the second diode 26, and when a voltage exceeding a predetermined threshold (for example 12V) is reached, a voltage is output to a gate of the current control transistor 9, as shown in Fig. 4(c), putting the current control transistor 9 into an on-state. At this time, the constant current $I_{IN}$ flows into a collector of the current control transistor 9, and $V_{IN}$ becomes approximately equal to 0V.

As a base current of the load isolating transistor 11 becomes approximately equal to 0, $I_{OUT}$ becomes approximately equal to 0. When the electrical charge of the smoothing capacitor 22 decreases owing to the determination circuit 6, the output voltage $V_{OUT}$ decreases, but when the output voltage $V_{OUT}$ becomes equal to or less than the predetermined threshold (for example, 11. 9V) according to the voltage monitoring circuit 8, the load isolating transistor 11 is changed back to an on-state by the current control transistor 9 being turned off, and the smoothing capacitor 22 is charged with current. Consequently, the output voltage $V_{OUT}$ is controlled by the voltage monitoring circuit 8 at a constant voltage with respect to an input of the constant current $I_{IN}$.

After the determination circuit 6 starts up, one selected signal of the operation test signal $I_{TEST2}$ and $I_{TEST1}$ is applied from the operation test device 15 to the testing detection resistor 23 via the switching diode 19. At this time, the determination circuit 6 detects values of voltage generated in the testing detection resistor 23 and the current detection resistor 5, and outputs the tripping signal $V_{TRIP}$ when a predetermined value is exceeded. When the tripping signal $V_{TRIP}$ is output, the thyristor 20 is turned on, as shown in Fig. 4(e). At the same time, the voltage monitoring circuit 8 is turned off, and output to the base of the current control transistor 9 changes to an off-state.

Also, as the control transistor 14 of the load isolating transistor 11 is turned on, the base voltage $V_B$ becomes approximately equal to 0, and the load isolating transistor 11 is turned off, because of which $I_{OUT}$ becomes approximately equal to 0. As impedance of the tripping coil 21 is greater than that of the determination circuit 6, which is a load of the power supply circuit, the input voltage $V_{IN1}$ rises. Current flowing into an emitter of the control transistor 14 at this time is in the region of several hundred microamps (for example, $530\mu A$) when the pull-up resistor 12 is of several tens of kilohms (for example, $47k\Omega$).

When the constant current $I_{IN}$ is several tens of milliamps (for example, 30mA), an operation is such that almost all the current flows into the tripping coil 21. Also, the current flowing into the tripping coil 21 is limited by the Zener voltage of the overvoltage protection Zener diode 10.

The operation test device 15 detects the voltage value of $V_{IN1}$, and detects that the breaker has operated when a predetermined threshold (for example, 15V) is exceeded. In order to ensure reliability of this breaker operation detection, a method is such that detection is carried out every several milliseconds, as in Fig. 4(i) and Fig. 4(j), and the matter that the breaker has performed a tripping operation is detected when, for example, $V_{IN1}$ in excess of 15V is detected twice or more every t2 = 5ms.

The load isolating transistor 11 is controlled so as to be turned off by the tripping signal $V_{TRIP}$ of the determination circuit 6 when a tripping operation is carried out, but as the power supply source is switched so that the electrical charge with which the smoothing capacitor 22 is charged becomes the power supply, the electrical charge of the smoothing capacitor 22 decreases because of current consumption occurring due to the determination circuit 6. Therefore, when the voltage supplied to the determination circuit 6 drops below a minimum operating voltage, the tripping signal $V_{TRIP}$ stops within the several milliseconds of t1, as in Fig. 4(f).

In the event that the tripping signal $V_{TRIP}$ is stopped, the control transistor 14 is turned off, and the load isolating transistor 11 is in an on-state at this point, power is also supplied to the determination circuit 6 in addition to the tripping coil 21, and after the tripping signal shown in Fig. 2(f) is turned off, the power supply circuit output voltage $V_{OUT}$ of Fig. 2(h) decreases, and the operation test device 15 cannot detect a tripping. In order for the operation test device 15 to carry out tripping detection, it is necessary for the power supply to the determination circuit 6 to be supplemented with only the electrical charge with which the smoothing capacitor 22 is charged until a count of a number of times tripping operation detection is carried out exceeds a threshold, as shown in Fig. 2(j), meaning that a large capacity smoothing capacitor is needed. In this case, a speed of a CO operation of the electronic circuit breaker, that is, a speed of carrying out a closing operation following seamlessly on from an opening operation, decreases, because of which a new problem occurs.

However, by utilizing the first diode 25, which is the power supply circuit output voltage switching means, and furthermore, by using the second diode 26, which is the voltage restricting means, for anode-to-cathode voltage $V_{ON}$ of the thyristor 20, the load isolating transistor 11 can be constantly maintained in an off-state while the operation test device 15 is detecting a tripping operation, meaning that a tripping operation can be detected with a small capacity smoothing capacitor 22. Hereafter, an operating principle whereby the capacity of the smoothing capacitor 22 can be reduced will be described in detail.

When the thyristor 20 is changed to an on-state by a tripping signal output by one of the instantaneous trip determination circuit 6a and the time-limit trip determination circuit 6b of the determination circuit 6, the base voltage $V_B$ of the load isolating transistor 11 when the on-state voltage $V_{ON}$ of the thyristor 20 is $V_{ON}$ = 1.2V and a forward voltage $V_{D3}$ of the first diode 25, which is the power supply circuit output voltage switching means, is $V_{D3}$ = 0.7V is such that

$$V_B = V_{ON} + V_{D3} = 1.2V + 0.7V = 1.9V.$$

Also, when a base-to-emitter voltage $V_{BE}$ necessary in order for the load isolating transistor 11 to be turned on is $V_{BE} = 0.6V$, and a forward voltage $V_{D1}$ of the backflow preventing diode 13 is $V_{D1} = 0.6V$, the output voltage $V_{OUT}$ is such that

$$V_{OUT} = V_B - V_{BE} - V_{D1} = (1.9V - 0.6V - 0.6V) = 0.7V.$$

Furthermore, owing to a forward voltage $V_{D2}$ of the second diode 26, which is the current restricting means, a voltage $V_{OUT2}$ applied to the determination circuit 6 is such that

$$V_{OUT2} = V_{OUT} - V_{D2} = 0.6V - V_{D2},$$

and in order for $V_{OUT2}$ to be approximately equal to 0, it is necessary that $V_{D2}$ is approximately equal to 0.6, but assuming that the output current $I_{OUT}$ is generated in the region of several tens of microamps (for example, $50\mu A$) provided that the forward voltage of the second diode 26 is in the region of 0.6V, $I_{IN} >> I_{OUT}$, and $I_{OUT}$ is approximately equal to 0.

Consequently, provided that the thyristor 20 is in an on-state, input impedance of the power supply circuit seen from the tripping operation detection voltage $V_{IN2}$ of the terminal 16 of the operation test device 15 is such that the electrical charge of the smoothing capacitor 22 is $0\mu C$, and is constant even when the determination circuit 6 is stopped, and the tripping operation detection voltage $V_{IN2}$ is stable, as in Fig. 4(h). Also, as the operation test device 15 can execute a tripping operation detection count for detecting, tripping operation detection can be carried out.

Consequently, provided that the capacity of the smoothing capacitor 22 is a capacity such that the thyristor can be turned on and the output voltage $V_{OUT}$ can be stabilized, the capacitor capacity can be reduced, and a reduction in size of the power supply circuit can be achieved, without problem. Furthermore, a high speed operation can be carried out by reducing the capacity of the smoothing capacitor 22.

According to the electronic circuit breaker 1B according to the first embodiment, as heretofore described, the capacity of the smoothing capacitor 22 can be reduced when the tripping coil 21 operates by including the first diode 25, which is the power supply circuit output voltage switching means, and the second diode 26, which is the voltage restricting means, because of which a reduction in size of the electronic circuit is achieved, and a high speed operation can be carried out by reducing the capacity of the smoothing capacitor 22.

Although the system comprising an electronic circuit breaker and an operation test device according to the first embodiment of the invention has been described heretofore, the embodiment can be modified or abbreviated as appropriate without departing from the scope of the invention as defined in the appended claims.

Reference Signs List

1A, 1B electronic circuit breaker, 2 alternating current electric path, 3 switching contact, 4 current transformer, 5 current detection resistor, 6 determination circuit, 6a instantaneous trip determination circuit, 6b time-limit trip determination circuit, 7 rectifier circuit, 8 voltage monitoring circuit, 9 current control transistor, 10 overvoltage protection Zener diode, 11 load isolating transistor, 12 pull-up resistor, 13 backflow preventing diode, 14 control transistor, 15 operation test device, 16, 17, 24 terminal, 18 rectifying diode, 19 switching diode, 20 thyristor, 21 tripping coil, 22 smoothing capacitor, 23 testing detection resistor, 25 first diode, 26 second diode.

**Claims**

1. A system comprising an electronic circuit breaker (1B) and an operation test device (15),
   wherein the electronic circuit breaker (1B), comprises:

   a switching contact (3), inserted in an alternating current electric path (2), on which a switching operation is carried out by a tripping coil (21);
   a rectifier circuit (7), connected to a secondary side of a current transformer (4) that detects a current flowing into the alternating current electric path (2), that converts a secondary side output current into a unidirectional current;

voltage restricting means (26);

a current detection resistor (5), connected to the rectifier circuit (7), that detects a current of the alternating current electric path (2);

a determination circuit (6), that is connected via the voltage restricting means (26), monitors a voltage generated by a current flowing into the current detection resistor (5), and causes the switching contact (3) to open via the tripping coil (21) when the monitored voltage exceeds a predetermined threshold; and

a testing detection resistor (23), connected to the current detection resistor (5), that is connected in series to an input terminal of the determination circuit (6);

wherein the operation test device (15), when the alternating current electric path (2) is not energized, inputs a constant current into a latter stage of the rectifier circuit (7) from an exterior via a connection connector, inputs a test signal into the testing detection resistor (23), and carries out a tripping operation test on the circuit breaker, **characterized in that** the electronic circuit breaker (1B) further comprises:

a first switching element (9) connected to an output side of the rectifier circuit (7);

a second switching element (11) that isolates a load from the output side of the rectifier circuit (7);

voltage switching means (25), connected to a control terminal of the second switching element (11), that switches an output voltage of a power supply circuit connected to a thyristor (20) connected in series to the tripping coil (21); and

a voltage monitoring circuit (8), connected via the voltage restricting means (26), that carries out a control of the first switching element (9);

wherein the voltage restricting means (26) are connected to an output side of the second switching element (11);

wherein the current detection resistor (5) detects a current of each phase of the alternating current electric path (2); and

wherein the determination circuit (6) is formed of an instantaneous trip determination circuit (6a) and a time-limit trip determination circuit (6b).

2. The system according to claim 1, wherein the voltage restricting means (26) of the electronic circuit breaker (1B) is a diode or a Zener diode.

3. The system according to claim 1 or 2, wherein the voltage switching means (25) of the electronic circuit breaker (1B) is a diode.

4. The system according to any one of claims 1 to 3, wherein each of the first switching element (9) and the second switching element (11) of the electronic circuit breaker (1B) is a bipolar transistor or a field effect transistor.

**Patentansprüche**

1. System umfassend einen elektronischen Schutzschalter (1B) und eine Funktionsprüfvorrichtung (15), wobei der elektronische Schutzschalter (1B), aufweist:

einen Schaltkontakt (3), der in einen elektrischen Wechselstrompfad (2) eingefügt ist, auf dem durch eine Auslösespule (21) ein Schaltvorgang ausgeführt wird;

eine Gleichrichterschaltung (7), die mit einer Sekundärseite eines Stromwandlers (4) verbunden ist, der einen in den elektrischen Wechselstrompfad (2) fließenden Strom erfasst, und die einen sekundärseitigen Ausgangsstrom in einen Gleichstrom umwandelt;

eine Spannungsbegrenzungseinrichtung (26);

einen Stromerfassungswiderstand (5), der mit der Gleichrichterschaltung (7) verbunden ist und der einen Strom des elektrischen Wechselstrompfades (2) erfasst;

eine Bestimmungsschaltung (6), die über die Spannungsbegrenzungseinrichtung (26) angeschlossen ist, eine durch einen in den Stromerfassungswiderstand (5) fließenden Strom erzeugte Spannung kontrolliert, und die mittels der Auslösespule (21) bewirkt, dass sich der Schaltkontakt (3) öffnet, wenn die überwachte Spannung eine vorbestimmte Schwelle überschreitet; und

einen Testerfassungswiderstand (23), der mit dem Stromerfassungswiderstand (5), der mit einem Eingangsanschluss der Bestimmungsschaltung (6) in Reihe geschaltet ist, verbunden ist;

wobei die Funktionsprüfvorrichtung (15), wenn der elektrische Wechselstrompfad (2) nicht unter Strom gesetzt ist, von außen über einen Verbindungsstecker einen konstanten Strom in eine letztere Abschnitt der Gleichrichterschaltung (7) eingibt, ein Testsignal in den Testerfassungswiderstand (23) eingibt und an dem Schutzschalter einen Auslösefunktionstest durchführt,
**dadurch gekennzeichnet, dass** der elektronische Schutzschalter (1B) ferner aufweist:

ein erstes Schaltelement (9), das mit einer Ausgangsseite der Gleichrichterschaltung (7) verbunden ist;
ein zweites Schaltelement (11), das eine Last von der Ausgangsseite der Gleichrichterschaltung (7) trennt;
eine Spannungsschalteinrichtung (25), die mit einem Steueranschluss des zweiten Schaltelements (11) verbunden ist, und die eine Ausgangsspannung einer Stromversorgungsschaltung, die mit einem Thyristor (20) verbunden ist, der in Reihe mit der Auslösespule (21) geschaltet ist, schaltet; und
eine Spannungsüberwachungsschaltung (8), die über die Spannungsbegrenzungseinrichtung (26) angeschlossen ist und die eine Steuerung des ersten Schaltelements (9) durchführt;

wobei die Spannungsbegrenzungseinrichtung (26) mit einer Ausgangsseite des zweiten Schaltelements (11) verbunden ist;
wobei der Stromerfassungswiderstand (5) einen Strom jeder Phase des elektrischen Wechselstrompfades (2) erfasst; und
wobei die Bestimmungsschaltung (6) aus einer Sofortauslöse-Bestimmungsschaltung (6a) und einer Zeitlimitauslöse-Bestimmungsschaltung (6b) gebildet ist.

2. System nach Anspruch 1, wobei die Spannungsbegrenzungseinrichtung (26) des elektronischen Schutzschalters (1B) eine Diode oder eine Z-Diode ist.

3. System nach Anspruch 1 oder 2, wobei die Spannungsschalteinrichtung (25) des elektronischen Schutzschalters (1B) eine Diode ist.

4. System nach einem der Ansprüche 1 bis 3, wobei sowohl das erste Schaltelement (9) als auch das zweite Schaltelement (11) des elektronischen Schutzschalters (1B) ein Bipolartransistor oder ein Feldeffekttransistor sind.

**Revendications**

1. Système comprenant un disjoncteur électronique (1B) et un dispositif de test de fonctionnement (15),
dans lequel le disjoncteur électronique (1B) comprend :

un contact de commutation (3), inséré dans un trajet électrique de courant alternatif (2), sur lequel une opération de commutation est réalisée par une bobine de déclenchement (21) ;
un circuit redresseur (7) connecté à un côté secondaire d'un transformateur de courant (4) qui détecte un courant circulant dans le trajet électrique de courant alternatif (2), qui convertit un courant de sortie de côté secondaire en courant unidirectionnel ;
des moyens de restriction de tension (26) ;
une résistance de détection de courant (5), connectée au circuit redresseur (7), qui détecte un courant du trajet électrique de courant alternatif (2) ;
un circuit de détermination (6), qui est connecté par les moyens de restriction de tension (26), surveille une tension générée par un courant circulant dans la résistance de détection de courant (5), et fait s'ouvrir le contact de commutation (3) via la bobine de déclenchement (21) quand la tension surveillée dépasse un seuil prédéterminé ; et

une résistance de détection de test (23), connectée à la résistance de détection de courant (5), qui est connectée en série à une borne d'entrée du circuit de détermination (6) ;
dans lequel le dispositif de test de fonctionnement (15), quand le trajet électrique de courant alternatif (2) n'est pas sous tension, entre un courant constant dans un dernier niveau du circuit redresseur (7) depuis un extérieur via un connecteur de connexion, entre un signal de test dans la résistance de détection de test (23), et effectue un test de fonctionnement de déclenchement sur le disjoncteur,
**caractérisé en ce que** le disjoncteur électronique (1B) comprend en outre :

un premier élément de commutation (9) connecté à un côté de sortie du circuit redresseur (7) ;
un deuxième élément de commutation (11) qui isole une charge du côté de sortie du circuit redresseur (7) ;

des moyens de commutation de tension (25), connectés à une borne de commande du deuxième élément de commutation (11), qui commutent une tension de sortie d'un circuit d'alimentation électrique connecté à un thyristor (20) connecté en série à la bobine de déclenchement (21) ; et

un circuit de surveillance de tension (8), connecté via les moyens de restriction de tension (26), qui effectue une commande du premier élément de commutation (9) ;

dans lequel les moyens de restriction de tension (26) sont connectés à un côté de sortie du deuxième élément de commutation (11) ;

dans lequel la résistance de détection de courant (5) détecte un courant de chaque phase du trajet électrique de courant alternatif (2) ; et

dans lequel le circuit de détermination (6) est formé d'un circuit de détermination de déclenchement instantané (6a) et d'un circuit de détermination de déclenchement à limite de temps (6b).

2. Système selon la revendication 1, dans lequel les moyens de restriction de tension (26) du disjoncteur électronique (1B) sont une diode ou une diode Zener.

3. Système selon la revendication 1 ou 2, dans lequel les moyens de commutation de tension (25) du disjoncteur électronique (1B) sont une diode.

4. Système selon l'une quelconque des revendications 1 à 3, dans lequel chacun du premier élément de commutation (9) et du deuxième élément de commutation (11) du disjoncteur électronique (1B) est un transistor bipolaire ou un transistor à effet de champ.

# FIG. 1

EP 3 595 113 B1

# FIG. 2

(a) OPERATION TEST DEVICE 15
    SUPPLY CURRENT $I_{IN}$

(b) POWER SUPPLY CIRCUIT
    OUTPUT VOLTAGE $V_{OUT}$

DETERMINATION
CIRCUIT MINIMUM
OPERATING
VOLTAGE

(c) VOLTAGE MONITORING CIRCUIT 8
    OUTPUT VOLTAGE

(d) TRANSISTOR 11
    BASE VOLTAGE $V_B$

(e) THYRISTOR 20 ANODE-TO-CATHODE
    VOLTAGE $V_{SR}$

THYRISTOR ON

(f) TRIPPING SIGNAL $V_{TRIP}$

$t 1$

(g) OPERATION TEST SIGNAL
    $I_{TEST1}$ OR $I_{TEST2}$

COUNT
CANNOT COUNT

(h) OPERATION TEST DEVICE 15
    TERMINAL 16 VOLTAGE $V_{IN2}$

TRIPPING
OPERATION
DETECTION
COUNT
THRESHOLD

(i) OPERATION TEST DEVICE 15
    TRIPPING OPERATION
    DETECTION TIMING

(j) OPERATION TEST DEVICE 15
    TRIPPING OPERATION
    DETECTION COUNT

$t 2$

TRIPPING
OPERATION
DETECTION
THRESHOLD

12

# FIG. 3

EP 3 595 113 B1

# FIG. 4

(a) OPERATION TEST DEVICE 15
   SUPPLY CURRENT $I_{IN}$

(b) POWER SUPPLY CIRCUIT
   OUTPUT VOLTAGE $V_{OUT}$

DETERMINATION
CIRCUIT MINIMUM
OPERATING
VOLTAGE

(c) VOLTAGE MONITORING
   CIRCUIT 8 OUTPUT VOLTAGE

(d) TRANSISTOR 11
   BASE VOLTAGE $V_B$

(e) THYRISTOR 20 ANODE-TO-
   CATHODE VOLTAGE $V_{SR}$

THYRISTOR ON

(f) TRIPPING SIGNAL $V_{TRIP}$

t 1

(g) OPERATION TEST SIGNAL
   $I_{TEST1}$ OR $I_{TEST2}$

CAN COUNT

(h) OPERATION TEST DEVICE 15
   TERMINAL 16 VOLTAGE $V_{IN2}$

TRIPPING
OPERATION
DETECTION COUNT
THRESHOLD

(i) OPERATION TEST DEVICE 15
   TRIPPING OPERATION
   DETECTION TIMING

t 2

(j) OPERATION TEST DEVICE 15
   TRIPPING OPERATION
   DETECTION COUNT

TRIPPING
OPERATION
DETECTION
THRESHOLD

14

**EP 3 595 113 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 8331748 A
- JP 9211089 A
- JP H09211089 A